# EUROPÄISCHE PATENTSCHRIFT

(11) **EP 2 997 406 B1**
(45) Veröffentlichungstag und Bekanntmachung des Hinweises auf die Patenterteilung: **29.09.2021**
(21) Anmeldenummer: 14741504.6
(22) Anmeldetag: 13.05.2014
(51) Int. Cl.: G02B 7/00, G02B 1/02, G01J 5/08, G01J 1/02, G01J 5/04, H01L 31/0232

(54) **VERFAHREN ZUR HERSTELLUNG VON IN EIN GEHÄUSE HERMETISCH DICHT EINLÖTBAREN FENSTERELEMENTEN UND DANACH HERGESTELLTE FREIFORMFENSTERELEMENTE**
METHOD FOR PRODUCING WINDOW ELEMENTS THAT CAN BE SOLDERED INTO A HOUSING IN A HERMETICALLY SEALED MANNER AND FREE-FORM WINDOW ELEMENTS PRODUCED IN ACCORDANCE WITH SAID METHOD
PROCÉDÉ DE FABRICATION D'ÉLÉMENTS DE FENÊTRE POUVANT ÊTRE BRASÉS DE MANIÈRE HERMÉTIQUE ET ÉTANCHE DANS UN BOÎTIER

(30) Priorität: 13.05.2013 DE 102013008478
(43) Veröffentlichungstag der Anmeldung: 23.03.2016
(73) Patentinhaber: JENOPTIK Optical Systems GmbH, 07745 Jena (DE); Micro-Hybrid Electronic GmbH, 07629 Hermsdorf (DE)
(72) Erfinder: GITTLER, Elvira, 07745 Jena (DE); BIERMANN, Steffen, 07629 Hermsdorf (DE); BRODE, Wolfgang, 07629 Hermsdorf (DE); STÖRZNER, Falko, 07586 Kraftsdorf (DE)
(74) Vertreter: Freitag, Joachim
(86) Internationale Anmeldenummer: PCT/DE2014/100165
(87) Internationale Veröffentlichungsnummer: WO 2014/183746

(56) Entgegenhaltungen:
- EP-A2- 1 727 210
- DE-A1- 4 433 521
- JP-A- 2009 276 691
- US-A1- 2004 104 460

## Beschreibung

Die Erfindung betrifft ein Verfahren zur Herstellung von in ein Gehäuse hermetisch dicht einlötbaren Fensterelementen mit optischer Beschichtung und nach dem Verfahren hergestellte Freiformfensterelemente. Derartige Fensterelemente sind insbesondere dafür geeignet, Gehäuse von Strahlungsdetektoren oder -quellen bei Gewährleistung optischer, insbesondere spektraler Funktionen hermetisch dicht (vakuumdicht) zu verschließen.

Im Stand der Technik ist aus der DE 10 2005 024 512 B3 ein Verfahren zur Herstellung von hermetisch dicht einlötbaren Fensterelementen bekannt, bei denen durch Aufbringung eines verbesserten Haftschichtsystems mit Barriereschicht und Interdiffusionsschicht ein Eindringen von Streulicht oder Störstrahlung vermieden wird. Die dabei hergestellten Fensterelemente resultieren aus rahmenförmigen Teilbereichen, die durch ihre rechteckige Form zwar gut verarbeitbar sind, aber bezüglich ihrer Einschränkung des Abstrahlwinkels bei flächenminimierten Sensoren bzw. Detektoren begrenzt sind. So führen die so hergestellten Fensterelemente bei gering dimensionierten Flächensensoren oder Image-Detektoren zu Einschränkungen bei der Anpassung an die vorhandenen Gehäuse und zu Qualitätsverlusten.

Ferner ist in der DE 10 2007 039 291 A1 ein optoelektronisches Halbleitermodul offenbart, das mit einem auf einem Chipträger montierten lichtemittierenden Halbleiterchip und einem Abdeckelement, das eine zumindest teilweise durchlässige Abdeckplatte über dem Halbleiterchip aufweist, und einem Rahmenteil zur seitlichen Ummantelung des Halbleiterchips ausgestattet ist, wobei Abdeckplatte und Rahmenteil fügeschichtlos durch anodisches Bonden miteinander verbunden sind. Rahmenteil und Chipträger lassen sich dann wie übliche metallische Chipträger und Kappen durch Löten verbinden.

Dokument JP2009276691 beschreibt ein Verfahren zur Herstellung eines mit optischen Filtern bestückten Fensterelements, bei dem die optischen Schichten mit einer Schutzschicht überdeckt werden, bevor die rechteckigen Fensterelemente mechanisch getrennt werden, ein die Filterschichten jeweils umgebender Randbereich des Fensters abgetragen und eine Metallschicht über die gesamte Fensteroberfläche inklusive der Schutzschicht aufgetragen wird. Zusammen mit der durch ein Lösungsmittel aufgelösten Schutzschicht wird auch die Metallschicht über den optischen Schichten entfernt, verbleibt aber auf dem Substratrand, an dem mittels Schleifscheibe eine Trennfuge im Substrat erzeugt ist.

Ferner ist auch bekannt, kreisförmige Fensterelemente einzeln herzustellen und diese entsprechend ihrer Zweckbestimmung in ein Gehäuse einzukleben.

Nachteilig hierbei ist jedoch der damit verbundene Handlungsaufwand einer Einzelfertigung und die Einschränkung hinsichtlich der Fenstergröße. Die Einzelfertigung gering dimensionierter Flächensensoren, Image-Detektoren und Endoskope (1 - 5 mm) ist daher sehr aufwändig und solch ein Verfahren für eine Serienfertigung eher ungeeignet. Zudem sind diese Elemente äußerst störanfällig und somit auch kostenintensiv. Des Weiteren wirkt sich bei geklebten Fensterelementen die Permeabilität (Gasdurchlässigkeit) des Klebers negativ auf die Langzeitstabilität darauf basierender Systeme aus, die eine 100% hermetisch gasdichte Verbindung (Vakuumtauglichkeit) benötigen. Mit geklebten Fenstern lassen sich nur quasihermetische Verbindungen herstellen. Im Unterschied hierzu können mit gelöteten Fensterelementen langzeitstabil hermetisch gasdichte und temperaturbeständige Systeme aufgebaut werden.

Ausgehend hiervon liegt der Erfindung die Aufgabe zugrunde, eine verbesserte Möglichkeit zur Herstellung von in ein Gehäuse hermetisch dicht einlötbaren optischen Fensterelementen mit optischer Beschichtung zu finden, die eine dauerhaft zuverlässige - auch bei thermischer Wechselbelastung - hermetisch gas- bzw. vakuumdichte Lötverbindung mit einem metallischen Gehäuse gestatten und weiterhin das Eindringen von Streu- und Störstrahlung in das Schichtsystem der optischen Beschichtung gering halten.

Dabei soll es möglich sein, Fensterelemente mit flexiblen Formvarianten (Freiformfenster) aus optisch durchlässigem, flachem Trägermaterial bereitzustellen, die bei einem gewünschten kleinen Format im Bereich zwischen 1 mm und 100 mm kosteneffizient herstellbar, hermetisch dicht (vakuumdicht) verlötbar und dauerhaft stabil für oben genannte Anwendungen sind.

Im Sinne der Erfindung werden unter Freiformflächen von optischen Fenstern solche Fensterelemente verstanden, die - bei flacher Grundform bevorzugt planparallel, aber im Spezialfall auch mit integrierten optischen Linsen und/oder Filterfunktionen - als Flächenumrissform rund, oval, sichelförmig, vieleckig, beispielsweise dreieckig, rechteckig, polygonal, aber auch halb-, drittel- oder viertelkreisförmig etc. ausgebildet sind, wobei alle Formen auch bevorzugt mit abgerundeten Ecken ausgeführt sein können. Die Umrissform kann auch entsprechend einer Zweckbestimmung der Fensterelemente in frei definierbarer Form gestaltet sein.

Erfindungsgemäß wird die Aufgabe bei einem Verfahren zur Herstellung von in ein Gehäuse hermetisch dicht einlötbaren Fensterelementen durch die Merkmale gemäß dem geltenden Anspruch 1 gelöst.

Vorteilhaft kann als gerichteter Bearbeitungsstrahl ein Laserstrahl, ein Partikelstrahl oder ein Elektronenstrahl verwendet werden.

In einer bevorzugten Ausführung wird mittels des gerichteten Bearbeitungsstrahls energiereicher Strahlung beim Abtragen des lokal bearbeiteten peripheren Randbereichs des Trägermaterials, der mindestens eine abgesenkte Stufe in einem inneren und eine weitere Stufe in einem äußeren Kantenbereich mit gerundeten Kanten mit Radien R zwischen 50 und 150 µm aufweist, um im Schritt e) durch das vollständige Beschichten mit dem Lötschichtsystem eine spannungsarme Metallisierung des lokal bearbeiteten peripheren Randbereichs sowie einen zusätzlichen Kantenumgriff für ein später angewendetes Lot der Lötschicht zu erhalten.

Zweckmäßig wird der lokal bearbeitete Randbereich mittels eines Reinigungsprozesses von losem und locker anhaftendem Material befreit und eine definierte Rauigkeit der Oberfläche eingestellt, wobei die Rauigkeit höchstens Ramax = 2,5 µm beträgt. Dabei kann der Reinigungsprozess bevorzugt durch eine Strahlbearbeitung mittels Laserstrahl, Partikelstrahl, Elektronenstrahl, Glasperlenstrahl oder Ätzflüssigkeitsstrahl erfolgt.

Unter dem technologischen Effektivitätsaspekt sowie aus Gründen der Nutzentechnologie wird bevorzugt eine Vielzahl von Fensterelementen auf dem waferförmigen Trägermaterial hergestellt.

Dazu wird vorzugsweise nach dem Schritt f) des Ablösens der Metallisierung von der optischen Beschichtung ein Ausschneiden der einzelnen Fensterelemente aus dem Trägermaterial entlang von Trennlinien vorgenommen.

In einer alternativen Variante kann nach dem Schritt d) des Abtragens der Randbereiche der Fensterelemente auch gleich anschließend das Ausschneiden der einzelnen Fensterelemente aus dem Trägermaterial entlang der Trennlinien erfolgen.

In beiden Varianten erfolgt zweckmäßig das Ausschneiden der Fensterelemente, indem das Trägermaterial entlang der Trennlinien von der Vorderseite her durchtrennt wird, wobei die Vorderseite die für die lötfähige Metallisierung vorgesehene Oberfläche des Trägermaterials ist.

Es erweist sich als vorteilhaft, wenn vor dem Durchtrennen des Trägermaterials zu den Trennlinien korrespondierend verlaufende Schwächungen an der Rückseite des Trägermaterials eingebracht werden. Dabei kann zusätzlich ein Haltesubstrat bereitgestellt und das Trägermaterial auf dem Haltesubstrat durch ein Haftmittel je Fensterelement angeheftet werden.

Zweckmäßig kann das Ausschneiden der Fensterelemente mittels eines gerichteten Bearbeitungsstrahls energiereicher Strahlung durch ein mehrfaches Überfahren der Trennlinien mit dem gerichteten Bearbeitungsstrahl erfolgen und es können gleichzeitig gerundete Kanten mit gewünschten Radien R entlang der Trennlinien erzeugt werden.

Beim Ausschneiden der Fensterelemente können durch das mehrfache Überfahren der Trennlinien mit dem gerichteten Bearbeitungsstrahl zusätzlich zu den gerundeten Kanten nach innen gegen eine Oberflächennormale des Fensterelements geneigte abgeschrägte Seitenflächen erzeugt werden.

In einer weiteren bevorzugten Ausführung kann das Ausschneiden der Fensterelemente durch ein mehrfaches Überfahren der Trennlinien mit dem gerichteten Bearbeitungsstrahl direkt im Zusammenhang mit dem durch den gerichteten Bearbeitungsstrahl erzeugten Abtragen der abgesenkten Stufe des Trägermaterials erfolgen und dabei können die gerundeten Kanten mit den Radien R im zwei- bis dreistelligen Mikrometerbereich entlang der Trennlinien erzeugt werden. Um die Resistenz der optischen Beschichtung gegen Ätzprozesse und mechanische Beanspruchung zu verbessern kann vorteilhaft als eine Abschlussschicht der optischen Beschichtung eine Siliziumnitrid-, Zinksulfid- oder eine DLC (Diamond-Like Carbon)-Schicht oder eine Schicht aus einem Oxid von Silizium, Magnesium, Aluminium oder eine Schicht aus einem Fluorid von Yttrium, Ytterbium, Barium oder eine Halbleiterschicht aus Germanium oder Silizium verwendet werden.

Als Schutzschicht und Lift-off-Make wird bevorzugt eine metallische Schutzschicht auf die optische Beschichtung aufgetragen. Dabei kann die Schutzschicht mit mindestens einem der metallischen Materialien aus der Gruppe Aluminium und Aluminiumlegierungen, wie Aluminium-Silizium-, Aluminium-Magnesium-, Aluminium-Lithium-Legierungen, und Nickel und Nickel-Eisen-Legierungen, erzeugt werden.

Zusätzlich kann die metallische Schutzschicht vor der Überdeckung mit dem Lötschichtsystem durch eine Polymerschicht ergänzt wird, wenn bei dicken Lötschichtsystemen der Lift-off-Prozess erleichtert werden soll. Es ist aber auch möglich als Schutzschicht ausschließlich eine Polymerschicht (z. B. eine Photolackschicht) auf die optische Beschichtung aufzutragen.

Die Aufgabe wird weiterhin gelöst durch Freiformfensterelemente für beliebig geformte Öffnungen eines Gehäuses zum hermetisch dichten Einlöten in das Gehäuse, die durch die Merkmale des geltenden Anspruchs 12 gekennzeichnet sind. Vorteilhafte Ausgestaltungen sind in den Ansprüchen 13 und 14 dargelegt.

Die nach einem oder mehreren der vorhergehenden Herstellungsvarianten hergestellten Freiformfensterelemente für beliebig geformte Öffnungen eines Gehäuses werden vorzugsweise zur Herstellung von gas- oder vakuumdichten optoelektronischen oder elektro-optischen Bauelementen verwendet.

Die Erfindung basiert auf der empirischen Erkenntnis, dass die bekannten zusätzlichen Haftvermittlerschichten zur Zuverlässigkeitssteigerung der hermetisch dichten Lötverbindung nicht den gewünschten dauerhaften Erfolg bei einer thermischen Wechselbelastung erbringen, sodass für die dauerhafte Garantie der Dichtigkeit der Gehäuse-Fenster-Verbindung ein noch innigerer Kontakt der Lötbeschichtung am Fenstermaterial hergestellt werden muss, der zudem die optischen Filterschichten technologisch nicht zusätzlich belastet und weiterhin die unerwünschte Fremdstrahlung (Streu- und andere Störstrahlung) vom Rand des Filtersystems gering hält. Des Weiteren soll die Fensterform nicht wie bisher auf rechteckige, quadratische oder kreisförmige Fenster beschränkt sein.

Gemäß der Erfindung werden diese Probleme gelöst, indem das Abtragen der optischen Beschichtung im Randbereich durch Strahlbearbeitung mit einem energiereichen Strahl (Laser-, Elektronen- oder Partikelstrahl) bis deutlich ins Substrat des Fensters (Abtragen einer Substratstufe von mehr als der Dicke der optischen Beschichtung) erfolgt, das zugleich mit einem die gewünschte optisch wirksame Fläche "umschreibenden" Materialabtrag die Herstellung beliebiger Freiformflächen gestattet, und bei definierter verbleibender Oberflächenrauigkeit der Abtragung einen direkten Auftrag der Metallisierung mit dem Lötschichtsystem ermöglicht. Dadurch reduziert sich das bereits vorbekannte Lift-off-Verfahren für die Lötmetallisierung von der optisch wirksamen Freiformfläche der einzelnen Fensterelemente allein auf die Unterätzung einer über der optischen Beschichtung zuvor aufgebrachten, für die Energiestrahlbearbeitung erforderlichen Schutzschicht, die somit eine Doppelfunktion erfüllt (Schutzschicht und Lift-off-Maske).

Hierdurch wird erreicht, dass einerseits keine zusätzliche Overall-Beschichtung mit Haftvermittlerschichten erforderlich ist, wodurch sich auch der Lift-off-Prozess des Lötsystems vereinfacht, und andererseits der strahloptisch ausgeführte Abtrag der optischen Beschichtung Freiformfenster ermöglicht, die für die beschichtungsfreie, zusätzlich abgestufte Randzone durch eine in (radialer) Breite und Tiefe gerundete Randgestaltung des Substrats eines Fensterelements eine spannungsarme Lötverbindung gestattet. Die Substratabstufung erübrigt eine zusätzliche Barriereschicht sowie eine Interdiffusionsschicht, wenn bestimmte Oberflächenrauigkeiten eingehalten werden, sodass das Verfahren zur Herstellung hermetisch gasdicht lötbarer Fensterelemente sich vereinfacht und zugleich die dauerhafte Zuverlässigkeit der hermetisch dichten Lötverbindung erhöht.

Die Erfindung erlaubt die Herstellung von optischen Fensterelementen, die eine dauerhaft zuverlässige - auch bei thermischer Wechselbelastung - hermetisch gas- bzw. vakuumdichte Lötverbindung mit einem metallischen Gehäuse sicherstellen und dabei auch das Eindringen von Streu- und Störstrahlung in das optische Schichtsystem geringhalten. Dabei wird außerdem die Herstellung von Freiformfensterflächen durch die Art des Randabtrags ermöglicht, die zugleich die Langzeitstabilität der Lötverbindung erhöht.

Die Erfindung wird nachfolgend anhand von Ausführungsbeispielen und Zeichnungen näher erläutert. Die Zeichnungen dazu zeigen:
- Fig. 1:: eine Grundvariante des erfindungsgemäßen Verfahrens zur Herstellung eines Fensterelements mit optischer Beschichtung und Lötmetallisierung,
- Fig. 2:: eine vorteilhafte Ausführung des Verfahrens zur Herstellung einer Mehrzahl von Fensterelementen,
- Fig. 3:: eine weitere bevorzugte Ausführung des Verfahrens zur Herstellung einer Mehrzahl von Fensterelementen,
- Fig. 4:: eine Anordnung von gleichen Fensterelementen auf einem Trägermaterial in Form eines Wafers im Hinblick auf beste Nutzentechnologie,
- Fig. 5:: eine perspektivische Darstellung einer Gehäusekappe mit erfindungsgemäß hergestellten Fensterelementen mit einem vergrößerten Ausschnitt des Randbereiches des Fensterelements als Schnittzeichnung mit der fertigen Lötverbindung,
- Fig. 6:: eine bevorzugte Anordnung von beliebigen unterschiedlichen Fensterelementen auf Trägermaterial in Form eines Wafers im Hinblick auf beste Nutzentechnologie für unterschiedlichste Anwendungen,
- Fig. 7A-7C: das charakteristische Transmissionsverhalten über der Wellenlänge jeweils für Fensterelemente verschiedener Trägermaterialien mit unterschiedlichen optischen Beschichtungen: A) Germaniumträger mit AR-Beschichtung (Entspiegelungsbeschichtung) für einen Wellenlängenbereich von 3 - 11 µm, B) Siliziumträger mit Langpass-Filter für 8 - 12 µm und C) Bariumfluoridträger mit Bandpass-Filter für 5,7 bis 7 µm.

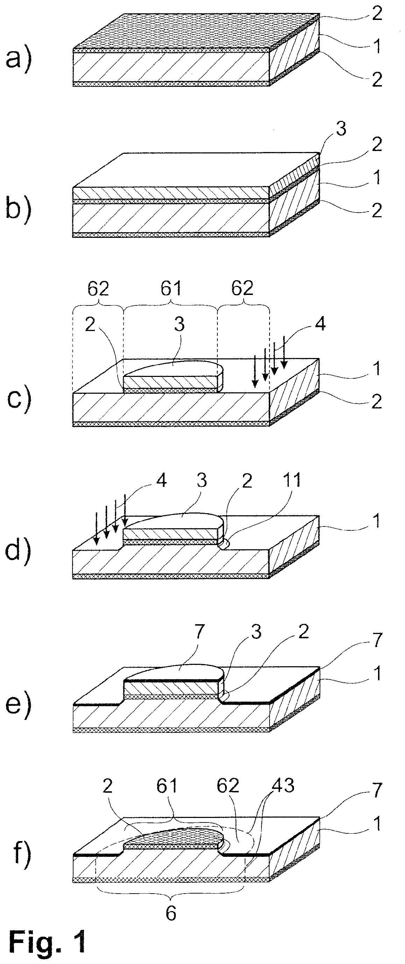

Das Verfahren zur Herstellung von in ein Gehäuse 9 hermetisch dicht einlötbaren Fensterelementen 6 weist in einer Grundvariante gemäß Fig. 1, die eine schematische Darstellung des Verfahrensablaufs zeigt, folgende Schritte auf:
a) Auftragen wenigstens einer optischen Beschichtung 2 auf mindestens eine Fläche eines optisch durchlässigen, flachen Trägermaterials 1,
b) Beschichten der optischen Beschichtung 2 mit einer Schutzschicht 3, die eine ätzbare Schicht im Sinne einer Opferschicht für eine diesbezüglich ätzresistente optische Beschichtung 2 ist,
c) selektives Entfernen der Schutzschicht 3 und der optischen Beschichtung 2 von dem Trägermaterial 1, indem für Fensterelemente 6 mit beliebiger geometrischer Gestalt mindestens eine gewünschte optisch wirksame Freiformfläche 61 in Randbereichen 62, welche die mindestens eine optisch wirksame Freiformfläche 61 peripher umschließen, durch lokale Bearbeitung mittels eines gerichteten Bearbeitungsstrahls 4 energiereicher Strahlung abgetragen wird, sodass die Schutzschicht 3 auf der optischen Beschichtung 2 als eine Maske zurückbleibt, welche die gewünschte optisch wirksame Freiformfläche 61 vollständig abdeckt,
d) Abtragen eines Teils des Trägermaterials 1 entlang des lokal bearbeiteten peripheren Randbereichs 62 mittels des gerichteten Bearbeitungsstrahls 4 energiereicher Strahlung, sodass mindestens eine abgesenkte Stufe 11, 12 definierter Rauigkeit in dem lokal bearbeiteten Randbereich 62 des Trägermaterials 1 entsteht, wobei die Stufe 11 mehr als die einfache Schichtdicke der optischen Beschichtung 2 unterhalb eines von der optischen Beschichtung 2 belegten Höhenniveaus des Trägermaterials 1 liegt,
e) Beschichten einer Oberfläche des Trägermaterials 1, welche die von der Schutzschicht 3 abgedeckte optische Beschichtung 2 und den lokal bearbeiteten peripheren Randbereich 62 des mindestens einen Fensterelements 6 aufweist, durch überdeckende Metallisierung 7 der besagten Oberfläche mit einer lötfähigen Beschichtung und
f) Ablösen der Metallisierung 7 über der optischen Beschichtung 2 durch einen Ätzprozess, der selektiv nur die Schutzschicht 3, aber nicht die optische Beschichtung 2 und nur minimal die Metallisierung 7 angreift, sodass die auf der Schutzschicht 3 haftende Metallisierung 7 durch Unterätzung geliftet wird und die Metallisierung 7 nur auf den lokal bearbeiteten, die optisch wirksamen Freiformflächen 61 umschließenden peripheren Randbereichen 62 erhalten bleibt.

Als Trägermaterial 1 kommen bevorzugt Silizium, Germanium, Bariumfluorid, Calciumfluorid, Zinksulfid oder auch Saphir (nur bis 5,5 µm transparent) zum Einsatz.

Optische Beschichtungen können von verschiedenster Art sein. Sie reichen von Entspiegelungsschichtsystemen (z B. AR-Filter 21) über verschiedenste spektrale Kanten- und Bandpassfilter bis zu Interferenzfiltersystemen mit sehr speziellen spektralen Charakteristiken (im Folgenden zusammengefasst als spektrales Filtersystem 22 oder abstrahiert als optische Beschichtung 2). Insbesondere letztgenannte Interferenzfiltersysteme werden vorzugsweise auf der (technologischen) Oberseite des Fensterelements 6, die auch die Metallisierung 7 für die Lötverbindung trägt, aufgebracht, die später im Gehäuse 9 die Innenseite des Fensterelements 6 darstellt. Die (technologische) Rückseite des Fensterelements 6, die später als Außenseite am Gehäuse 9 installiert ist, wird dagegen häufiger - aber nicht ausschließlich - mit Entspiegelungsbeschichtungen, Absorptionsfiltern und Reflexionsfiltern belegt.

Bei der Auswahl der Schutzschicht 3 für die auf der Oberseite des Fensterelements 6 aufgebrachte optische Beschichtung 2 wird vor allem das gute nasschemische Ätzverhalten, aber auch die Resistenz gegen die Abtragungsprodukte des hochenergetischen Bearbeitungsstahls 4 berücksichtigt. Hier kommen vor allem Materialien, wie Aluminium sowie Legierungen damit (z. B. Al-Si, Al-Mg, Al-Li) oder auch Nickel und Nickel-Eisen-Legierungen, zum Einsatz, wobei große Schichtdicken (zwischen 100 nm und 5 µm) für ausreichende Schichtstabilität und kurze Ätzdauern (zwischen 1 min und 10 min, optimal 2 - 3 min) für den Lift-off-Prozess bevorzugt sind. Alternative Schutzschichten 3 aus Chrom oder Titan erfordern dafür lediglich geringere Schichtdicken (zwischen 50 nm und 1 µm).

Für die Schichtenabtragung durch den Bearbeitungsstrahl 4 werden aber mitunter größere Schichtdicken der Schutzschicht 3 bis zu 8 µm gefordert, um ausreichend Schutz (z. B. gegen Plasmaspritzer) zu gewähren. In solchen Fällen können auch dickere Polymerschichten (z. B. Photolack) oder ein Verbund aus den vorgenannten Metall- und Polymerschichten gebildet werden.

Als wesentlicher Verfahrensschritt kommt neben der vollständigen Abtragung der Schutzschicht 3 und der optischen Beschichtung 2 die fortgesetzte abgestufte Materialabtragung des Trägermaterials 1 mittels des Bearbeitungsstrahls 4 hinzu. Dazu wird zuallererst eine definierte Rauigkeit des Randbereiches 62 um die gewünschte optisch wirksame Freiformfläche 61 geschaffen, die im Bereich zwischen 0,5 µm und 2,5 µm möglichst homogen eingestellt wird, um die sichere und dauerhafte Haftung des Lötschichtsystems 71 zu ermöglichen. Dabei wird die Homogenität durch umkreisende randparallele Verläufe der Abtragungslinien des Bearbeitungsstrahls 4 um die optisch wirksame Freiformfläche 61 herum erreicht. Andererseits wird durch die Abtragung mindestens einer Stufe 11, die mehr als die Schichtdicke der optischen Beschichtung 2 unterhalb des Basisniveaus der optischen Beschichtung 2 abgesenkt ist, gewährleistet, dass eine spätere Störlichteinkopplung vom Randbereich 62 der Metallisierung 7 in die optische Beschichtung 2 weitgehend unterdrückt ist.

Da es bei der Herstellung von Fensterelementen 6 stets auch um technologische Effektivität geht, ist für die Herstellung einer Vielzahl von unterschiedlichen Fensterelementen 6 auf einem gemeinsamen Trägermaterial 1 (sog. Wafer) auch ein Ausschneiden der einzelnen Fensterelemente 6 erforderlich, das als Prozessschritt aber an verschiedenen Stellen des Beschichtungs- und Abtragungsprozesses erfolgen kann. Dazu sind in den folgenden Verfahrensvarianten unterschiedliche Möglichkeiten mit angegeben.

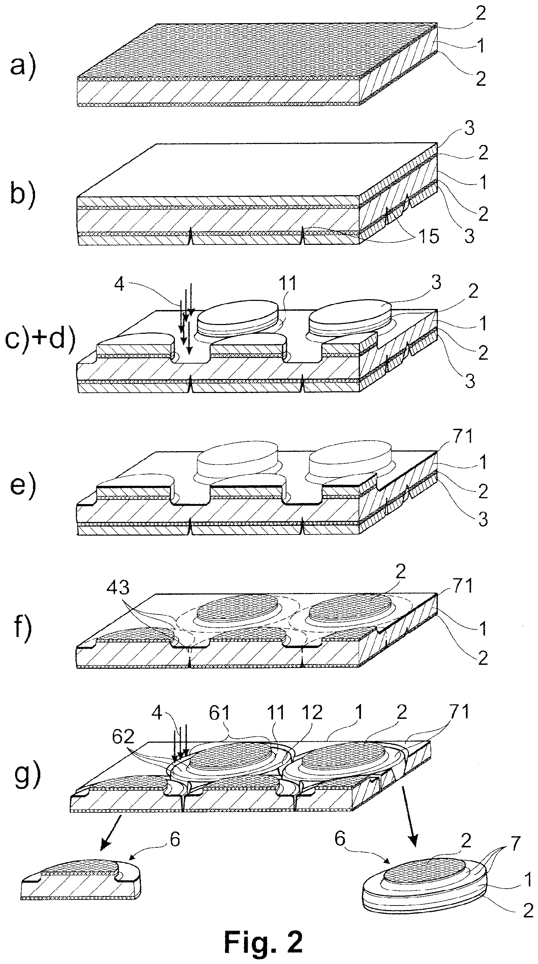

In einer ersten Variante des Verfahrens gemäß Fig. 2 wird das optisch durchlässige, flache Trägermaterial 1, das z. B. aus Silizium (Si) oder Germanium (Ge) oder Saphir (Al₂O₃) oder Quarzglas (SiO₂) oder Kalziumfluorid (CaF₂) besteht und dessen Größe ausreichend ist für eine Vielzahl von Fensterelementen 6, nacheinander mit folgenden Schritten bearbeitet:
a) Auftragen von optischen Beschichtungen 2 (z. B. Vergütungsschicht, Antireflexbeschichtung oder Filterbeschichtung) auf beiden Oberflächen des Trägermaterials 1,
b) Beschichten der beiden Oberflächen des Trägermaterials 1 mit einer Schutzschicht 3 für die optischen Beschichtungen 2 (z. B. metallische Schichten für Laserbearbeitung), wobei auf der Rückseite des Trägermaterials 1 Einkerbungen 15 entsprechend der gewünschten Gestalt der optisch wirksamen Freiformfläche 61 der Fensterelemente 6 vorgenommen werden, um beim späteren Ausschneiden der Fensterelemente 6 Ausbrüche der Kanten zu vermeiden,
c) selektives Entfernen der Schutzschicht 3 und der optischen Beschichtung 2 vom Trägermaterial 1 in dem/n Randbereich/en 62, von denen die optisch wirksamen Freiformflächen 61 der Fensterelemente 6 umschlossen werden, mittels einer gerichteten Strahlbearbeitung (Laserbearbeitung, Elektronenstrahlverfahren, Partikelstrahlverfahren und dergleichen oder auch Wasserstrahlverfahren) und
d) Bearbeiten der optisch wirksamen Freiformflächen 61 der Fensterelemente 6 mittels eines gerichteten Bearbeitungsstrahls 4 eines gütegeschalteten oder modulierbaren Festkörperlasers, indem durch Lasersublimation eine stress- und rückstandsarme Bearbeitung in dem/n Randbereich/en 62 erfolgt,
e) Auftragen einer Metallisierung 7, die in den strahlbearbeiteten Randbereichen 62 auf dem Trägermaterial 1 haftet, vorzugsweise durch physikalische Gasphasenabscheidung (PVD-Verfahren) von Lötschichtsystemen 71 aus beispielsweise:
   Titan (Ti) - Platin (Pt) - Gold (Au) oder
   Titan (Ti) - Palladium (Pd) - Gold (Au) oder
   Chrom (Cr) - Eisen-Nickel-Legierung (FeNi) - Gold-Nickel-Legierung (AuNi) oder
   Kupfer-Nickel-Gold-Legierung (CuNiAu) - Nickel (Ni) oder
   durch chemische Verfahren mit Nickel (Ni) und Gold (Au) und
f) Liften des auf der Schutzschicht 3 haftenden Lötschichtsystems 71, indem im nachfolgenden Ätzprozess, der nur selektiv die auf den optisch wirksamen Freiformflächen 61 aufgebrachte Schutzschicht 3 angreift, während das Lötschichtsystem 71 wenig und die optische(n) Beschichtung(en) 2 nicht angegriffen werden, die Schutzschicht 3 entfernt wird, wobei die Schutzschicht 3 eine Lift-off-Maske für die optische Beschichtung 2 darstellt, sodass die Metallisierung 7 nur auf dem Trägermaterial 1 in Form einer Lötringstruktur in den Randbereichen 62 um die optisch wirksame(n) Freiformfläche(n) 61 erhalten bleibt, und
g) Ausschneiden der Fensterelemente 6 mittels des Bearbeitungsstrahles 4 eines gütegeschalteten oder modulierbaren Festkörperlasers aus dem Trägermaterial 1, indem vorderseitig die zu den rückseitigen Einkerbungen 15 (mit der gewünschten Gestalt der optisch wirksamen Freiformflächen 61 der Fensterelemente 6) kongruent gewählten Trennlinien 43 mit dem Bearbeitungsstrahl 4 des Lasers abgefahren werden.

Beispielhafte Parameter eines Laserstrahls für den Schichtenabtrag liegen vorzugsweise bei einem Spotdurchmesser von 30 µm bis 60 µm, einer Pulsfrequenz von 1 kHz bis 1000 kHz bei einer Laserleistung von 5 W bis 60 W. Durch Regelung der induzierten Flächenenergie (mittels der Art der Strahlablenkung) wird die Eindringtiefe des Laserstrahls und damit das Volumen des Materialabtrages bestimmt und somit ein weitgehend homogener und benetzungs-/beschichtungsfähiger Untergrund mit einer definierten Oberflächenrauigkeit von höchstens Raₘₐₓ = 2,5 µm für die Aufnahme des lötfähigen Lötschichtsystems 71 erzeugt.

Gegenüber bekannten mechanischen Abtragverfahren können beim Schichtenabtrag insbesondere Kerbrissspannungen in der optischen Beschichtung 2 verhindert werden.

Die Schutzschicht 3 für die optisch wirksamen Freiformflächen 61 ist in einer ersten Ausführung eine metallische Schutzschicht 3, bevorzugt aus Aluminium (AI), das unter definierten Prozessbedingungen beim Sputtern (z. B. Substrattemperatur < 180°C und relativ hohen Arbeitsdrücken von 1,066 Pa< p < 2,250 Pa) in Schichtdicken von 0,5 µm bis 5 µm abgeschieden wird, um eine grobkristalline Struktur zu erzeugen.

Diese Struktur wird gegebenenfalls durch ein Anätzen dekoriert, sodass das Aluminium im Bereich der Laserlichtwellenlänge (von bevorzugt 1 µm) auf Grund der entstandenen Oberflächenrauigkeit ein geringes Reflexionsvermögen besitzt.

Mit der Schutzschicht 3, die für die Ausbildung einer effektiven Lift-off-Maske eine Gesamtdicke von bis zum Drei- bis Fünffachen der Dicke des Lötschichtsystems 71 aufweisen kann, werden die Kontaminationen aus Laserschmauch und Plasmaspritzern, die üblicherweise beim Laserverfahren auftreten, verhindert und durch Unterätzung der Schutzschicht 3n als Lift-off-Maske benutzt, um die Metallisierung 7 oberhalb der optischen Beschichtung 2 abzulösen. Unter Anwendung der obigen grundsätzlichen Dickenanpassung der Schutzschicht 3 wird eine reine Al-Schicht mit Dicken von > 100 nm und < 5 µm zur Anwendung kommen. Werden dickere Schutzschichten 3 (z. B. bis zu 8 µm) benötigt, können als Materialien für die Schutzschicht 3 auch eine Polymerschicht (z. B. bekannter Photolack) oder ein Verbund aus Metall und Polymer zum Einsatz kommen. Alternativ zu Aluminium sind für metallische Schutzschichten 3 auch Aluminiumlegierungen (wie z. B. Aluminium-Silizium-, Aluminium-Magnesium- oder Aluminium-Lithium-Legierungen) sowie Nickel und Nickel-Eisen-Legierungen einsetzbar.

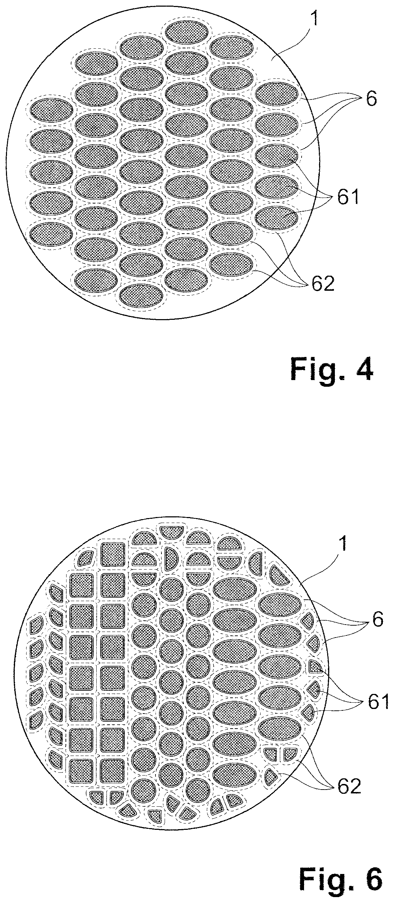

Mögliche Freiformvarianten der Fensterelemente 6 sind anhand der Figuren 2 bis 6 zu erkennen. Es versteht sich, dass Kombinationen aus den Formen der Fensterelemente 6 und den Formen des Trägermaterials 1 (Wafer oder Platten im Bereich von 0,2 mm bis 6 mm Dicke mit optischen Beschichtungen 2 für UV-Licht, IR-Licht und sichtbares Licht) möglich sind und durch den offenbarten Gegenstand der Erfindung umfasst werden. Für eine gemäß Fig. 4 und Fig. 6 gewählte Nutzentechnologie der optimalen Flächenausnutzung sind zum Ausschneiden der einzelnen Fensterelemente 6 Stegbreiten zwischen 0,5 mm und 1 mm sinnvoll bzw. ausreichend, wenn bei der vorgeschlagenen Strahlbearbeitung auch das Ausschneiden mit einem Bearbeitungsstrahl 4 energiereicher Strahlung (z. B. Laserstrahl) erfolgt.

Die Strahlbearbeitung ist vorteilhaft dadurch charakterisiert, dass durch eine erste Phase der Strahlbearbeitung die metallische Schutzschicht 3, die auch die Lasereinkopplung in die optische Beschichtung 2 (auch in hochreflektierende Vergütungsschicht) initiiert, die optische Beschichtung 2 abgetragen und verschmolzen wird, wodurch eine definierte (im Bereich 0,5 µm < Ra < 2,5 µm wählbare) und weitgehend homogene Oberflächenrauigkeit entsteht, die eine Strahleinkopplung unabhängig von den Eigenschaften der einzelnen optischen Schichten sichert, ohne dass ein Speziallaser benötigt wird, und in einer zweiten Phase ein Teil des Trägermaterials 1 mit mindestens einer Stufe 11 (mit einer Höhe von mehr als der Gesamtdicke der optischen Beschichtung 2) unterhalb des Basisniveaus der optischen Beschichtung 2 abgetragen und mit der oben angegebenen Oberflächenrauigkeit fertiggestellt wird. Bevorzugt wird die Stufe 11 auf das Doppelte der Schichtdicke der optischen Beschichtung 2 abgesenkt.

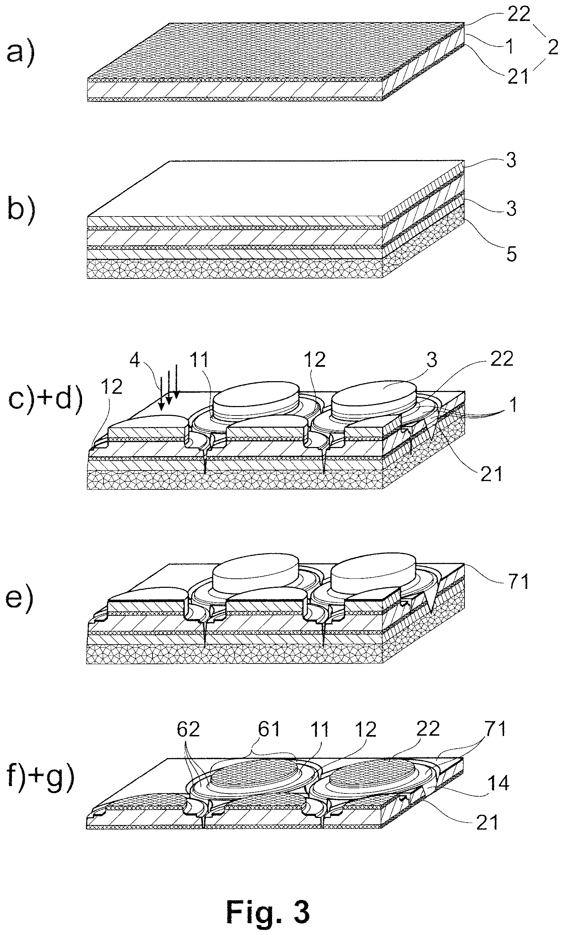

In einer zweiten Variante des Verfahrens gemäß Fig. 3 wird das optisch durchlässige, flache Trägermaterial 1 nacheinander mit folgenden Schritten bearbeitet:
a) Auftragen von unterschiedlichen optischen Beschichtungen 2 auf beiden Oberflächen des Trägermaterials 1 gemäß der Darstellung in Fig. 3, indem auf der einen Oberfläche eine Entspiegelungsbeschichtung in Form eines AR-Filters 21 und auf der anderen Oberfläche ein spektrales Filtersystem 22 aufgebracht wird,
b) Beschichten der beiden Oberflächen des Trägermaterials 1 mit einer Schutzschicht 3 aus einem Polymer (z. B. negativ arbeitender Photolack) für die optischen Beschichtungen 2, wobei auf der Rückseite des Trägermaterials 1 ein zusätzliches Haltesubstrat 5 so angeheftet wird, dass die gewünschten Fensterelemente 6 (siehe Fig. 2) jeweils (beispielsweise mit doppelseitigem Klebeband) mindestens punktuell fixiert sind,
c) selektives Entfernen der Schutzschicht 3 und der optischen Beschichtung 2 vom Trägermaterial 1 in dem/n Randbereich/en 62, von denen die optisch wirksamen Freiformflächen 61 der Fensterelemente 6 umschlossen werden, mittels einer gerichteten Strahlbearbeitung mit einem Bearbeitungsstrahl 4 und weitergehendes
d) Bearbeiten der optisch wirksamen Freiformflächen 61 der Fensterelemente 6 mittels des Bearbeitungsstrahls 4 zur Herausarbeitung der wenigstens einen Stufe 11 im Trägermaterial 1, indem durch Lasersublimation eine stress- und rückstandsarme Bearbeitung in dem/n Randbereich/en 62 der Fensterelemente 6 erfolgt, wonach unmittelbar das
g) Ausschneiden der Fensterelemente 6 entsprechend der gewünschten Gestalt der Fensterelemente 6 mittels eines Bearbeitungsstrahls 4 in Form eines Elektronenstrahls erfolgt, und anschließend fortgesetzt wird, wie bereits im Verfahrensablauf gemäß Fig. 2 aufgeführt, mit dem
e) Auftragen einer Metallisierung 7 mit dem Lötschichtsystem 71, vorzugsweise durch physikalische Gasphasenabscheidung ([Physical Vapor Deposition] PVD-Verfahren) von Lötschichtsystemen 71, die in den strahlbearbeiteten Randbereichen 62 auf dem Trägermaterial 1 haften, und
f) Liften der auf der Schutzschicht 3 haftenden Metallisierung 7, indem in einem Ätzprozess, der selektiv die vorher aufgebrachte Schutzschicht 3 angreift, diese im Lift-off-Prozess entfernt wird, sodass nur eine Metallisierung 7 als Lötringstruktur auf dem Trägermaterial 1 in den Randbereichen 62 um die optisch wirksame(n) Freiformfläche(n) 61 erhalten bleibt, und
g) gleichzeitiges Ablösen der Fensterelemente 6 von dem Haltesubstrat 5, wodurch die Fensterelemente 6 vereinzelt werden.

In einer besonderen Ausführung erfolgt die Strahlbearbeitung (z. B. durch Laserablation) in der Stufe 11 und einer weiteren Stufe 12 (nur in Fig. 3, Schritt c) bzw. d) gezeichnet) derart, dass im Lötschichtsystem 71 im Randbereich 62 um die optisch wirksame Freiformfläche 61 des Fensterelements 6 eine Stufe 11 im planaren Lötbereich von 50 µm - 200 µm, die unterhalb der Basisfläche der optischen Beschichtung 2 etwas tiefer als die Dicke der optischen Beschichtung 2 abgesenkt ist, vorzugsweise bis zum Zweifachen der optischen Beschichtungsdicke liegt und im äußeren Randbereich 62 eine weitere Stufe 12 im Bereich von 200 µm - 500 µm erzeugt wird.

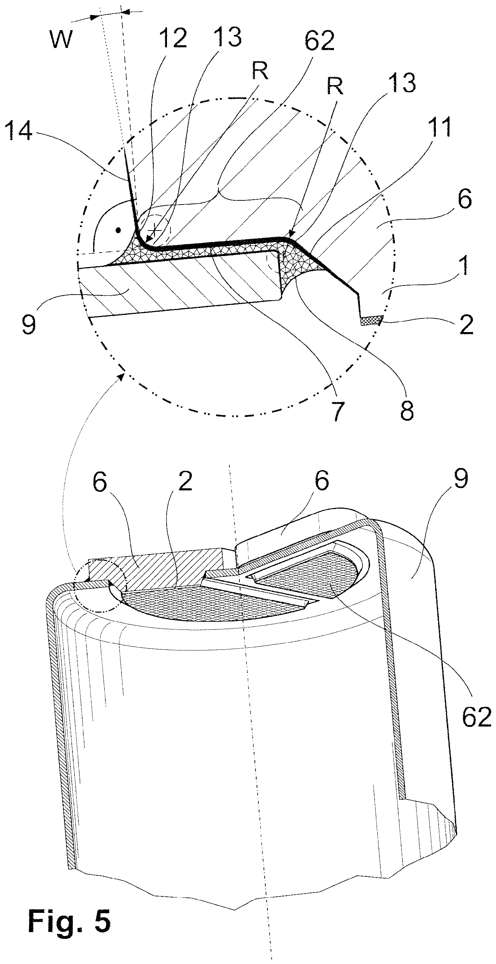

Durch die weitere Stufe 12, die auch nur als gerundete Kante 13 mit einem Radius R zwischen 50 und 150 µm ausgebildet sein kann (wie in Fig. 5 gezeigt), wird gesichert, dass die Metallisierung 7 nicht nur planar auf der Kontaktfläche des Fensterelements 6 zum Gehäuse 9 aufgebracht wird, sondern auch die Kante des Fensterelements 6 mit einer Lötschicht 8 umschichtet wird und damit im thermischen oder auch mechanischen Belastungsfall Kerbrissbildungen minimiert werden (siehe Fig. 2, Fig. 3 und insbesondere die Detailzeichnung in Fig. 5). Dabei gewährleistet die Stufe 11 zur Absenkung des Kontaktflächenniveaus unter das Grundniveau der optischen Beschichtung 2 eine die Gehäusekante umgreifende Lotanbindung, ohne dass von der Lötschicht 8 in die Filterschichten der optischen Beschichtung 2 Reflexions- oder Streulicht oder beliebiges anderes Störlicht eingetragen wird.

Außerdem trägt die Stufe 11 des Trägermaterialabtrags bis unter die Basisfläche der optischen Beschichtung 2 dazu bei, dass die Dicke der Schutzschicht 3, die üblicherweise das Drei- bis Fünffache der gewünschten Dicke des darüber liegenden Lötschichtsystems 71 aufweisen sollte, um ausreichende Stabilität für den Lift-off-Prozess zur gesicherten Freilegung der optischen Beschichtung 2 zu haben, reduziert werden kann, weil eine hohe laterale Angriffszone für das Ätzmittel auf die Schutzschicht 3 vorliegt. Dadurch kann die Schutzschicht 3 bis auf eine Dicke reduziert werden, die minimal größer oder gleich der Dicke des Lötschichtsystems 71 ist.

Zudem wird durch die Laserbearbeitung die Oberfläche des Trägermaterials 1 so in der Rauigkeit strukturiert, dass eine vergrößerte Oberfläche entsteht, die nach der Metallisierung 7 für die Lotanbindung zur Verfügung steht und so zu einer verbesserten Systemstabilität hinsichtlich des hermetisch dichten Fügesystems beiträgt. Durch die mittels Rauigkeit, aber auch durch die abgerundete Kante 13 und eine abgeschrägte Seitenfläche 14 erzeugte Oberflächenvergrößerung der Lötkontaktflächen kann bei verbesserter Systemstabilität der hermetischen Abdichtung auch die sogenannte Stegbreite der Randbereiche 62 der Fensterelemente 6 von üblicherweise 500 µm bis 800 µm auf bis zu 100 µm abgesenkt werden, wobei ein optimaler Bereich zwischen 300 und 500 µm liegt. Während für die gerundeten Kanten 13 vorzugsweise Radien R zwischen 50 und 150 µm, optimal 80-100 µm, zur Anwendung kommen, sind die abgeschrägten Seitenflächen 14 der Fensterelemente 6 zum bearbeiteten Randbereich 62 als Lötkontaktfläche hin geneigt (deutlicher sichtbar im vergrößerten Ausschnitt von Fig. 5, wobei ein Abschrägungswinkel W der Außenkante zwischen 1° und 15° gegenüber der Flächennormale der Lötkontaktfläche geeignet gewählt wird und Abschrägungswinkel zwischen 8°-12° bevorzugt sind.

In Fig. 5 ist des Weiteren ein Gehäuse 9, in das wenigstens zwei Fensterelemente 2 unterschiedlicher Form eingesetzt sind, in einer Schnittdarstellung gezeigt. Die Fensterelemente 6 sind dabei viertel- oder halbkreisförmige Freiformflächen 62 mit gerundeten Ecken. Die optische Beschichtung 2 ist - ohne Beschränkung der Allgemeinheit - nur auf der Innenseite des Fensterelements 6 angebracht. Im vergrößerten Ausschnitt sind dann erst die Metallisierung 7 sowie die Lötschicht 8 zu erkennen. Wesentlich ist dabei die Ausbildung aller Kantenübergänge des Fensterelements 6 als gerundete Kanten 13, wodurch sich das Lotmaterial der Lötschicht 8 spannungsarm und haltbarer an die Lötringsstruktur des Fensterelements anschmiegt. Die Dicke der Lötschicht 8 richtet sich in erster Linie nach der gewählten Rauigkeit der als Stufe 11 abgetragenen Oberfläche des Fensterelements 6 und liegt zwischen 300 nm und 5 µm, bevorzugt zwischen 1 bis 3 µm, wobei die größeren Dicken bei größerer Oberflächenrauigkeit (von bis zu 2,5 µm) zum Einsatz kommen.

Bei einer optischen Beschichtung 2 (Anti-Reflexion = AR und/oder spektrale Filter) durch die metallische Schutzschicht 3 kann die Lasereinkopplung in die optischen Schichten der optischen Beschichtung 2 einfacher initiiert werden. Dies kann durch Aufrauung mittels Anätzen der Al-Schicht (die > 100 nm und nicht größer als 5 µm sein sollte) oder dünner absorbierender Schichten aus Cr, Ti usw. (die eine Schichtdicke zwischen 50 nm und 1 µm aufweisen) unterstützt werden.

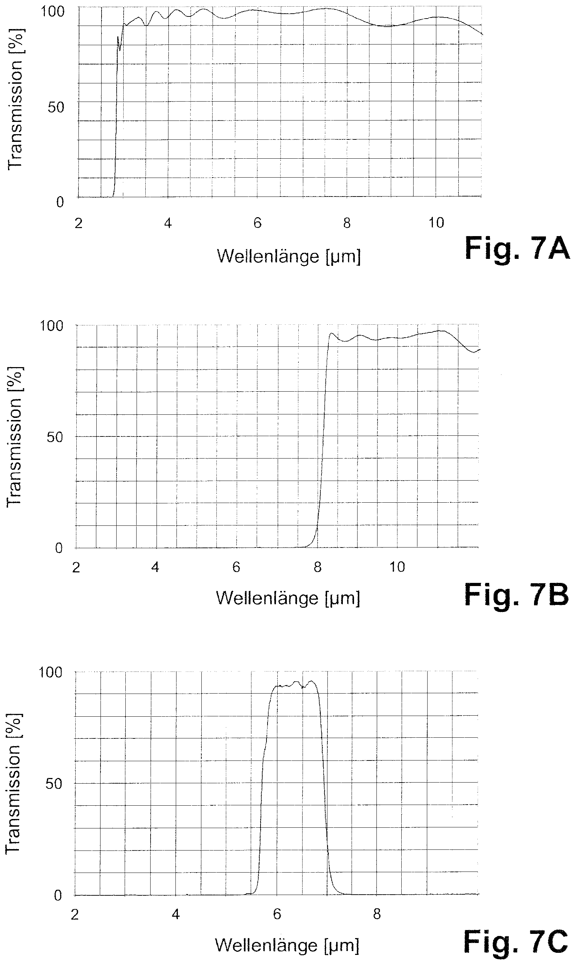

Beispiele für mögliche optische Beschichtungen 2 eines Fensterelements 6, die auf einem Wafer als Trägermaterial 1 aufgebracht sind und deren wellenlängenabhängige Transmissionscharakteristika Fig. 7A-C zeigen, sind beispielsweise eine Entspiegelungsbeschichtung (AR-Filter 21) für den Bereich 3 - 11 µm auf einem Ge-Substrat (Fig. 7A) oder als Beispiel für eine optische Beschichtung 2, die bevorzugt auf der Außenseite, aber auch alternativ auf der Innenseite des Fensterelements 6 aufgetragen sein kann, ein Langpass-Filter für 8 - 12 µm auf einem Si-Substrat (Fig. 7B) oder ein Bandpass-Filter für 5,7 - 7 µm auf einem BaF2-Substrat (Fig. 7C).

Zur Resistenzerhöhung der optischen Beschichtung 2 kann vorteilhaft eine obere Abschlussschicht aufgetragen werden, die eine Siliziumnitrid-, Zinksulfid- oder eine DLC-Schicht (Diamond-Like Carbon Layer) oder eine Schicht aus einem Oxid von Silizium, Magnesium, Aluminium oder eine Schicht aus einem Fluorid von Yttrium, Ytterbium, Barium oder eine Halbleiterschicht aus Germanium oder Silizium sein kann.

Der überwiegende Teil der verfügbaren optischen Beschichtungen 2 (z. B. AR-Filter 21 und / oder Filtersystem 22) wirken für die hier verwendete Laserwellenlänge entweder transparent oder reflektierend. Durch die erzeugte metallische Schutzschicht 3 wird eine prozessstabile Absorption der Strahlungsenergie im Material gewährleistet. Damit wird eine Sublimation/Ablation der Schutzschicht 3, der optischen Beschichtung 2 und des Trägermaterials 1 ermöglicht.

In einer Ausführungsvariante ist die metallische Schutzschicht 3 aus Aluminium (AI), wobei das AI durch niedrig konzentrierte NaOH (1...5%) gelöst wird.

In weiteren Ausführungen des erfindungsgemäßen Verfahrens können als Schutzschicht 3 auch Nickel oder Nickellegierungen, wie Eisen-Nickel-Legierungen, oder auch Aluminiumlegierungen, wie beispielsweise Aluminium-Silizium-, Aluminium-Magnesium- oder Aluminium-Lithium-Legierungen, angewendet werden.

Das Verfahren kann ferner dadurch optimiert werden, dass nach der partiellen ablativen Entfernung der metallischen Schutzschicht 3 oder der Polymerschutzschicht (z. B. Photolackschicht) und der optischen Beschichtung 2 die optisch wirksame Freiformfläche 61 komplett ausgeschnitten wird und die Fensterelemente 6 zuvor partiell derart auf dem Haltesubstrat 5, wie in Fig. 3 gezeigt, durch selektives Aufkleben oder Anpasten fixiert worden sind, dass sie in dieser Variante gereinigt und mit dem Lötschichtsystem 71 beschichtet werden können.

Die Technologiefolge sieht dabei wie folgt aus:
ao) erste Reinigung (üblicherweise wässrig und mit Ultraschall),
   a) Auftragen der optischen Beschichtung(en) 2,
   b) Aufbringen der Schutzschichten 3, bevorzugt beidseitig,
c₀₁) Anätzen der Schutzschicht 3 zur verbesserten Lasereinkopplung,
c₀₂) Vorbereitung des Haltesubstrats 5 mit Klebepads oder Pastensiebdruck,
c₀₃) Aufkleben eines Wafers mit der Lötseite nach oben auf das Haltesubstrat 5,
   c) erste Laserbearbeitungsstufe (Entfernen von Schutzschicht 3 und optischer Beschichtung 2),
   d) zweite Laserbearbeitungsstufe (Ausschneiden der Flächenstruktur der Fensterelemente 6),
eo) zweite Reinigung,
   e) Beschichtung mit dem Lötschichtsystem 71,
   g) Ausschneiden der Fensterelemente 6 und Ablösen vom Haltesubstrat 5, Magazinierung,
   f) Lift-off der Metallisierung 7 von den optisch wirksamen Freiformflächen 61 durch Unterätzen der Schutzschicht 3.

Es wird eine optische Beschichtung 2 verwendet, deren Abschlussschicht resistent gegen schwache Alkalien ist, die zur Rückätzung der Schutzschicht 3 angewendet werden. Als Abschlussschicht eignen sich hierzu insbesondere eine Siliziumnitrid-, Zinksulfid- oder eine DLC (Diamond.Like Carbon)-Schicht.

### Bezugszeichenliste

- 1: Trägermaterial
- 11: Stufe (des Trägermaterialabtrags)
- 12: weitere Stufe (des Trägermaterialabtrags)
- 13: gerundete Kante (des Fensterelements 6)
- 14: abgeschrägte Seitenfläche (des Fensterelements 6)
- 15: (rückseitige) Einkerbung
- 2: optische Beschichtung
- 21: AR-Filter
- 22: (spektrales) Filtersystem
- 3: Schutzschicht
- 4: Bearbeitungsstrahl (energiereicher Strahlung)

- 43: Trennlinien (zum Ausschneiden der Fensterelemente 6)
- 5: Haltesubstrat
- 6: Fensterelement
- 61: optisch wirksame Freiformfläche
- 62: Randbereich (Lötrand)
- 7: Metallisierung
- 71: Lötschichtsystem
- 8: Lötschicht
- 9: Gehäuse
- R: Radius
- W: Abschrägungswinkel (der Seitenfläche)

### Bezugszeichenliste

- 1: Trägermaterial
- 11: Stufe (des Trägermaterialabtrags)
- 12: weitere Stufe (des Trägermaterialabtrags)
- 13: gerundete Kante (des Fensterelements 6)
- 14: abgeschrägte Seitenfläche (des Fensterelements 6)
- 15: (rückseitige) Einkerbung
- 2: optische Beschichtung
- 21: AR-Filter
- 22: (spektrales) Filtersystem
- 3: Schutzschicht
- 4: Bearbeitungsstrahl (energiereicher Strahlung)

- 43: Trennlinien (zum Ausschneiden der Fensterelemente 6)
- 5: Haltesubstrat
- 6: Fensterelement
- 61: optisch wirksame Freiformfläche
- 62: Randbereich (Lötrand)
- 7: Metallisierung
- 71: Lötschichtsystem
- 8: Lötschicht
- 9: Gehäuse
- R: Radius
- W: Abschrägungswinkel (der Seitenfläche/Stufe)

## Patentansprüche

1. Verfahren zur Herstellung von in ein Gehäuse (9) hermetisch dicht einlötbaren Fensterelementen (6), bei dem optisch durchlässiges, flaches Trägermaterial (1), dessen Größe ausreichend ist für eine Vielzahl von Fensterelementen (6), nacheinander mit folgenden Schritten bearbeitet wird:
a) Auftragen wenigstens einer optischen Beschichtung (2) auf mindestens eine Fläche des optisch durchlässigen, flachen Trägermaterials (1),
b) Beschichten der optischen Beschichtung (2) mit einer Schutzschicht (3), die eine ätzbare Schicht im Sinne einer Opferschicht ist,
c) selektives Entfernen der Schutzschicht (3) und der optischen Beschichtung (2) von dem Trägermaterial (1), indem für Fensterelemente (6) mindestens eine gewünschte optisch wirksame Fläche in Randbereichen (62), die mindestens eine optisch wirksame Fläche peripher umschließen, durch lokale Bearbeitung abgetragen wird, sodass die Schutzschicht (3) auf der optischen Beschichtung (2) als eine Maske zurückbleibt, welche die mindestens eine optisch wirksame Fläche vollständig abdeckt,
d) Abtragen eines Teils des Trägermaterials (1) entlang des lokal bearbeiteten peripheren Randbereichs (62), bis dieser unterhalb eines von der optischen Beschichtung (2) belegten Höhenniveaus des Trägermaterials (1) abgesenkt ist,
e) Beschichten einer Oberfläche des Trägermaterials (1), welche die von der Schutzschicht (3) abgedeckte optische Beschichtung (2) und den lokal bearbeiteten peripheren Randbereich (62) des mindestens einen Fensterelements (6) aufweist, durch eine überdeckende Metallisierung (7),
f) Ablösen der Metallisierung (7) über der optischen Beschichtung (2) durch einen Ätzprozess, der selektiv die Schutzschicht (3) und die auf der Schutzschicht (3) haftende Metallisierung (7) durch Unterätzung liftet, sodass nur die Metallisierung (7) auf den peripheren Randbereichen (62) erhalten bleibt, und
g) Ausschneiden einzelner Fensterelemente (6) aus dem Trägermaterial (1) entlang von Trennlinien (43)
**dadurch gekennzeichnet, dass**
- das selektive Entfernen der Schutzschicht (3) und der optischen Beschichtung (2) in den Randbereichen (62) in Schritt c) durch lokale Bearbeitung mittels eines gerichteten Bearbeitungsstrahls (4) energiereicher Strahlung durchgeführt wird, wodurch Fensterelemente (6) als beliebig geformte optisch wirksame Freiformfläche (61) mit wenigstens abschnittsweise gekrümmtem Randbereich (62), der die optisch wirksame Freiformfläche (61) peripher umschließt, erzeugt werden,
- das Abtragen des Trägermaterials (1) in Schritt d) mittels des gerichteten Bearbeitungsstrahls (4) so erfolgt, dass eine Stufe (11) den peripheren Randbereich (62) um mehr als die einfache Schichtdicke der optischen Beschichtung (2) unterhalb eines von der optischen Beschichtung (2) belegten Höhenniveaus absenkt und eine weitere Stufe (12) an einem äußeren Randbereich (62) eine weitere Absenkung erzeugt, wobei die eine Stufe (11) und die weitere Stufe (12) mit gerundeten Flächen vom Trägermaterial (1) durch die Bearbeitung mit dem gerichteten Bearbeitungsstrahl (4) abgetragen werden und der Randbereich (62) von der einen Stufe (11) bis einschließlich der weiteren Stufe (12) eine durch den gerichteten Bearbeitungsstrahl (4) erzeugte definierte homogene Rauigkeit (62) erhält, und
- das Ausschneiden der Fensterelemente (6) durch den gerichteten Bearbeitungsstrahl (4) vorgenommen wird und zwar
entweder nach dem Schritt f) des Ablösens der Metallisierung (7) oder bereits nach dem Schritt d) des Abtragens der Randbereiche (62) der Fensterelemente (6).

2. Verfahren nach Anspruch 1, wobei mittels des gerichteten Bearbeitungsstrahls (4) energiereicher Strahlung beim Abtragen des lokal bearbeiteten peripheren Randbereichs (62) des Trägermaterials (1) die abgesenkten Stufen (11, 12) in einem inneren und einem äußeren Kantenbereich mit gerundeten Kanten (13) mit Radien (R) zwischen 50 und 150 µm erzeugt werden, um in Schritt e) durch das vollständige Beschichten mit dem Lötschichtsystem (71) eine spannungsarme Metallisierung (7) des lokal bearbeiteten peripheren Randbereichs (62) sowie einen zusätzlichen Kantenumgriff für ein später angewendetes Lot zu erhalten.

3. Verfahren nach Anspruch 1, wobei der lokal bearbeitete Randbereich (62) mittels eines Reinigungsprozesses von losem und locker anhaftendem Material befreit und eine Rauigkeit der Oberfläche von höchstens Raₘₐₓ = 2,5 µm eingestellt wird.

4. Verfahren nach Anspruch 1 bis 3, wobei der gerichtete Bearbeitungsstrahl (4) zum Abtragen, Ausschneiden und Reinigen ein Laserstrahl, Partikelstrahl, Elektronenstrahl, Glasperlenstrahl oder Ätzflüssigkeitsstrahl ist.

5. Verfahren nach Anspruch 1, wobei
- das Ausschneiden der Fensterelemente (6) erfolgt, indem das Trägermaterial (1) entlang der Trennlinien (43) beginnend von der Vorderseite, die eine für die lötfähige Metallisierung (7) vorgesehene Oberfläche des Trägermaterials (1) ist, durchtrennt wird,
- das Trägermaterial (1) vor dem Durchtrennen auf dem Haltesubstrat (5) vermittels eines Haftmittels je Fensterelement (6) angeheftet wird und
- ein Vereinzeln der im Schritt g) aus dem Trägermaterial (1) ausgeschnittenen Fensterelemente (2) durch Ablösen der Fensterelemente (2) von dem Haltesubstrat (5) erfolgt.

6. Verfahren nach Anspruch 5, wobei vor dem Anheften auf dem Trägersubstrat (1) und dem Durchtrennen des Trägermaterials (1) zu den Trennlinien (43) korrespondierend verlaufende Schwächungen an der Rückseite des Trägermaterials (1) eingebracht werden.

7. Verfahren nach einem der Ansprüche 5 bis 6, wobei durch ein mehrfaches Überfahren der Trennlinien (43) mit einem gerichteten Bearbeitungsstrahl (4) energiereicher Strahlung
- das Ausschneiden der Fensterelemente (6) erfolgt und dabei gerundete Kanten (13) mit Radien (R) entlang der Trennlinien (43) erzeugt werden oder
- das Ausschneiden der Fensterelemente (6) im Zusammenhang mit dem Abtragen der abgesenkten Stufe (11) des Trägermaterials (1) erfolgt und dabei gerundete Kanten (13) mit Radien (R) im zwei- bis dreistelligen Mikrometerbereich entlang der Trennlinien (43) erzeugt werden.

8. Verfahren nach Anspruch 7, wobei beim Ausschneiden der Fensterelemente (6) durch ein mehrfaches Überfahren der Trennlinien (43) mit dem gerichteten Bearbeitungsstrahl (4) zusätzlich zu den gerundeten Kanten (13) nach innen gegen eine Oberflächennormale des Fensterelements (6) geneigte abgeschrägte Seitenflächen (14) erzeugt werden.

9. Verfahren nach Anspruch 1, wobei als eine Abschlussschicht der optischen Beschichtung (2) eine Siliziumnitrid-, Zinksulfid- oder eine DLC (Diamond-Like Carbon)-Schicht oder eine Schicht aus einem Oxid von Silizium, Magnesium, Aluminium oder eine Schicht aus einem Fluorid von Yttrium, Ytterbium, Barium oder eine Halbleiterschicht aus Germanium oder Silizium verwendet wird.

10. Verfahren nach Anspruch 1, wobei als Schutzschicht (3) eine metallische Schutzschicht (3) auf die optische Beschichtung (2) aufgetragen wird.

11. Verfahren nach Anspruch 1, wobei als Schutzschicht (3) eine Polymerschicht auf die optische Beschichtung (2) aufgetragen wird.

12. Freiformfensterelemente für beliebig geformte Öffnungen eines Gehäuses (9) zum hermetisch dichten Einlöten in das Gehäuse (9) mit wenigstens einer optischen Beschichtung (2) auf mindestens einer Fläche eines optisch durchlässigen, flachen Trägermaterials (1), mit einem um eine Stufe (11) abgesenkten und mindestens eine optisch wirksame Fläche peripher umschließenden Randbereich (62), wobei die eine Stufe (11) im peripheren Randbereich (62) um die optisch wirksame Fläche bis unterhalb eines von der optischen Beschichtung (2) belegten Höhenniveaus des Trägermaterials (1) abgetragen und durch eine Metallisierung (7) überdeckt ist, **dadurch gekennzeichnet, dass**
- der periphere Randbereich (62) eine durch lokale Abtragung mit einem gerichteten Bearbeitungsstrahl (4) energiereicher Strahlung erzeugte homogene definierte Rauigkeit aufweist,
- die mindestens eine von dem durch lokale Bearbeitung mit dem gerichteten Bearbeitungsstrahl (4) abgetragenen peripheren Randbereich (62) umschlossene optisch wirksame Fläche eine Freiformfläche (61) von beliebiger geometrischer Gestalt mit mindestens abschnittsweise gekrümmtem Randbereich (62) ist,
- der periphere Randbereich (62) im Bereich der einen Stufe (11) bezüglich des von der optischen Beschichtung (2) belegten Höhenniveaus des Trägermaterials (1) um mehr als die einfache Schichtdicke der optischen Beschichtung (2) abgesenkt und durch eine weitere Stufe (12) im äußeren Randbereich weiter abgesenkt ist,
- die eine Stufe (11) und die weitere Stufe (12) ins Trägermaterial (1) mit gerundeten Flächen abgesenkt sind und
- der Randbereich (62) von der einen Stufe (11) bis zur weiteren Stufe (12) eine aufgrund der gleichen Abtragung mittels des gerichteten Bearbeitungsstrahls (4) homogene definierte Rauigkeit (62) aufweist und durch eine Metallisierung (7) in Form eines Lötschichtsystems (71) überdeckt ist.

13. Freiformfensterelemente nach Anspruch 12, **dadurch gekennzeichnet, dass** die eine abgesenkte Stufe (11) in einem inneren und die weitere Stufe (12) in einem äußeren Kantenbereich gerundete Kanten (13) mit Radien (R) zwischen 50 und 150 µm aufweisen.

14. Freiformfensterelemente nach Anspruch 12 oder 13, **dadurch gekennzeichnet, dass** im Lötschichtsystem (71) im Randbereich (62) um die optisch wirksame Freiformfläche (61) des Fensterelements (6) die eine Stufe (11) in einem planaren Lötbereich von 50 µm - 200 µm und im äußeren Randbereich (62) die weitere Stufe (12) im Bereich von 200 µm - 500 µm erzeugt wird.

15. Verwendung der Freiformfensterelemente nach einem der Ansprüche 12 bis 14 für beliebig geformte Öffnungen eines Gehäuses (9) zur Herstellung von gas- oder vakuumdichten optoelektronischen oder elektro-optischen Bauelementen.

## Claims

1. A method for producing window elements (6) that can be soldered into a housing (9) in a hermetically sealed manner, wherein an optically transparent, flat carrier material (1), whose size is sufficient for a plurality of window elements (6), is processed by the following sequence of steps:
a) applying at least one optical coating (2) to at least one surface of the optically transparent, flat carrier material (1),
b) coating the optical coating (2) with a protective layer (3) which is an etchable layer in the sense of a sacrificial layer,
c) selectively removing the protective layer (3) and the optical coating (2) from the carrier material (1) by removing, for window elements (6), at least one desired optically active area in edge regions (62) which peripherally enclose at least one optically active area, by local processing, so that the protective layer (3) remains on the optical coating (2) as a mask which completely covers the at least one optically active area,
d) removing a portion of the carrier material (1) along the locally processed peripheral edge region (62) until the latter is lowered below a height level of the carrier material (1) occupied by the optical coating (2),
e) coating a surface of the carrier material (1) with a covering metallisation layer (7), said surface comprising the optical coating (2) covered by the protective layer (3) and the locally processed peripheral edge region (62) of the at least one window element (6),
f) removing the metallisation layer (7) over the optical coating (2) by an etching process which selectively lifts the protective layer (3) and the metallisation layer (7), adhering to the protective layer (3), by underetching so that only the metallisation layer (7) on the peripheral edge regions (62) remains, and
g) cutting out individual window elements (6) from the carrier material (1) along separating lines (43),
**characterised in that**
- the selective removal of the protective layer (3) and the optical coating (2) in the edge regions (62) in step c) is carried out by local processing by means of a directed processing beam (4) of high-energy radiation, whereby window elements (6) are produced as an arbitrarily shaped, optically active free-form surface (61) with an edge region (62) which is curved at least in sections and peripherally encloses the optically active free-form surface (61),
- the removal of the carrier material (1) in step d) by means of the directed processing beam (4) is effected in such a way that one step (11) lowers the peripheral edge region (62) by more than the single layer thickness of the optical coating (2) below a height level occupied by the optical coating (2) and a further step (12) produces a further lowering at an outer edge region (62), wherein the one step (11) and the further step (12) with rounded surfaces are removed from the carrier material (1) by the processing with the directed processing beam (4) and the edge region (62) from the one step (11) up to and including the further step (12) receives a defined homogeneous roughness produced by the directed processing beam (4), and
- the cutting out of the window elements (6) is carried out by the directed processing beam (4), namely
either after step f) of detaching the metallisation layer (7) or already after step d) of removing the edge regions (62) of the window elements (6).

2. The method according to claim 1, wherein by means of the directed processing beam (4) of high-energy radiation during the removal of the locally processed peripheral edge region (62) of the carrier material (1), the lowered steps (11, 12) are produced in an inner and an outer edge region with rounded edges (13) having radii (R) between 50 and 150 µm, in order to obtain, in step e), by the complete coating with the solder layer system (71), a low-stress metallisation layer (7) of the locally processed peripheral edge region (62) as well as an additional edge contour for a subsequently applied solder.

3. The method according to claim 1, wherein the locally processed edge region (62) is freed from loose and loosely adhering material by means of a cleaning process and a surface roughness of at most Raₘₐₓ = 2.5 µm is set.

4. The method according to claims 1 to 3, wherein the directed processing beam (4) for removal, cutting and cleaning is a laser beam, particle beam, electron beam, glass bead jet or etching liquid jet.

5. The method according to claim 1, wherein
- the window elements (6) are cut out by cutting the carrier material (1) along the separating lines (43) starting from the front surface, which is a surface of the carrier material (1) intended for the solderable metallisation layer (7),
- the carrier material (1) is adhered to the holding substrate (5) by means of one adhesive per window element (6) before being cut, and
- the window elements (6) cut out of the carrier material (1) in step g) are separated by detaching the window elements (6) from the holding substrate (5).

6. The method according to claim 5, wherein weakened areas extending in correspondence to the separating lines (43) are introduced on the rear surface of the carrier material (1) prior to adhesion to the carrier material (1) and cutting through the carrier material (1).

7. The method according to any one of claims 5 to 6, wherein, by passing a directed processing beam (4) of high-energy radiation over the separating lines (43) multiple times,
- the window elements (6) are cut out and rounded edges (13) with radii (R) are produced along the separating lines (43), or
- the cutting out of the window elements (6) takes place in connection with the removal of the lowered step (11) of the carrier material (1), thereby producing rounded edges (13) with radii (R) in the two- to three-digit micrometre range along the separating lines (43).

8. The method according to claim 7, wherein, when the window elements (6) are cut out, bevelled lateral surfaces (14) inclined inwards towards a surface normal of the window element (6) are produced in addition to the rounded edges (13) by passing the directed processing beam (4) over the separating lines (43) multiple times.

9. The method according to claim 1, wherein a silicon nitride, zinc sulphide or DLC (Diamond-Like Carbon) layer or a layer of an oxide of silicon, magnesium, aluminium or a layer of a fluoride of yttrium, ytterbium, barium or a semiconductor layer of germanium or silicon is used as a cover layer of the optical coating (2).

10. The method according to claim 1, wherein a metallic protective layer (3) is applied to the optical coating (2) as a protective layer (3).

11. The method according to claim 1, wherein a polymer layer is applied to the optical coating (2) as a protective layer (3).

12. Free-form window elements for arbitrarily shaped openings of a housing (9) for hermetically sealed soldering into the housing (9) with at least one optical coating (2) on at least one surface of an optically transparent, flat carrier material (1), with an edge region (62) lowered by one step (11) and peripherally surrounding at least one optically active surface, wherein the one step (11) in the peripheral edge region (62) is removed around the optically active surface to below a height level of the carrier material (1) occupied by the optical coating (2) and is covered by a metallisation layer (7), **characterised in that**
- the peripheral edge region (62) has a homogeneous defined roughness produced by local removal with a directed processing beam (4) of high-energy radiation,
- the at least one optically active surface enclosed by the peripheral edge region (62) removed by local processing with the directed processing beam (4) is a free-form surface (61) of any geometric shape with an edge region (62) which is curved at least in sections,
- the peripheral edge region (62) in the region of the one step (11) is lowered with respect to the height level of the carrier material (1) occupied by the optical coating (2) by more than the single layer thickness of the optical coating (2) and is further lowered by a further step (12) in the outer edge region,
- the one step (11) and the further step (12) are lowered into the carrier material (1) with rounded surfaces and
- the edge region (62) from the one step (11) to the further step (12) has a homogeneous defined roughness due to the same removal by means of the directed processing beam (4) and is covered by a metallisation layer (7) in the form of a solder layer system (71).

13. The free-form window elements according to claim 12, **characterised in that** the one lowered step (11) in an inner edge region and the further step (12) in an outer edge region have rounded edges (13) with radii (R) between 50 and 150 µm.

14. The free-form window elements according to claim 12 or 13, **characterised in that** in the solder layer system (71) in the edge region (62) around the optically active free-form surface (61) of the window element (6) the one step (11) is produced in a planar soldering range of 50 µm - 200 µm and in the outer edge region (62) the further step (12) is produced in the range of 200 µm - 500 µm.

15. Use of the free-form window elements according to any one of claims 12 to 14 for arbitrarily shaped openings of a housing (9) for the production of gas-tight or vacuum-tight optoelectronic or electro-optical components.

## Revendications

1. Procédé de fabrication d'éléments de fenêtre (6) qui peuvent être soudés hermétiquement dans un boîtier (9), dans lequel procédé un matériau de support (1) plat et optiquement transparent, dont la taille est suffisante pour une pluralité d'éléments de fenêtre (6), est traité successivement par les étapes suivantes :
a) application d'au moins un revêtement optique (2) sur au moins une surface du matériau de support (1) plat et optiquement transparent,
b) revêtement du revêtement optique (2) avec une couche protectrice (3) qui est une couche gravable au sens d'une couche sacrificielle,
c) enlèvement sélectif de la couche protectrice (3) et du revêtement optique (2) du matériau de support (1) en enlevant au moins une surface optiquement active souhaitée dans des régions de bord (62) qui entourent périphériquement au moins une surface optiquement active, pour des éléments de fenêtre (6) par usinage local, de sorte que la couche protectrice (3) reste sur le revêtement optique (2) sous forme d'un masque qui recouvre complètement ladite au moins une surface optiquement active,
d) enlèvement d'une partie du matériau de support (1) le long de la région de bord périphérique (62) usinée localement jusqu'à ce qu'elle soit abaissée en dessous d'un niveau de hauteur du matériau de support (1) occupé par le revêtement optique (2),
e) revêtement d'une surface du matériau de support (1), qui comprend le revêtement optique (2) recouvert par la couche protectrice (3) et la région de bord périphérique (62) usinée localement de l'au moins un élément de fenêtre (6), par une couche de métallisation de recouvrement (7),
f) détachement de la couche de métallisation (7) sur le revêtement optique (2) par un procédé de gravure qui soulève sélectivement la couche protectrice (3) et la couche de métallisation (7) adhérant à la couche protectrice (3) par sous-gravure de sorte que seule la couche de métallisation (7) sur les régions de bord périphériques (62) reste, et
g) découpe d'éléments de fenêtre individuels (6) à partir du matériau de support (1) le long des lignes de séparation (43),
**caractérisé en ce que**
- l'enlèvement sélectif de la couche protectrice (3) et du revêtement optique (2) dans les régions de bord (62) à l'étape c) est effectué par usinage local au moyen d'un faisceau d'usinage dirigé (4) d'un rayonnement à haute énergie, de sorte que des éléments de fenêtre (6) sont produits sous forme d'une surface de forme libre optiquement active (61) de forme arbitraire avec une région de bord (62) qui est incurvée au moins par sections et entoure périphériquement la surface de forme libre optiquement active (61),
- l'enlèvement du matériau de support (1) à l'étape d) au moyen du faisceau d'usinage dirigé (4) est effectué de telle sorte qu'une marche (11) abaisse la région de bord périphérique (62) de plus de l'épaisseur d'une seule couche du revêtement optique (2) en dessous d'un niveau de hauteur occupé par le revêtement optique (2) et qu'une marche supplémentaire (12) produise un autre abaissement au niveau d'une région de bord extérieure (62), où ladite marche (11) et la marche supplémentaire (12) avec des surfaces arrondies sont enlevées du substrat (1) par l'usinage avec le faisceau d'usinage dirigé (4) et la région de bord (62) de ladite marche (11) jusqu'à la marche supplémentaire (12) incluse obtient une rugosité homogène définie produite par le faisceau d'usinage dirigé (4) et
- la découpe des éléments de fenêtre (6) est effectuée par le faisceau d'usinage dirigé (4), à savoir
soit après l'étape f) de détachement de la couche de métallisation (7) ou déjà après l'étape d) d'enlèvement des régions de bord (62) des éléments de fenêtre (6).

2. Procédé selon la revendication 1, dans lequel, au moyen du faisceau d'usinage dirigé (4) d'un rayonnement à haute énergie pendant l'enlèvement de la région de bord périphérique (62) usinée localement du matériau de support (1), les marches abaissées (11, 12) sont produites dans une région d'arêtes intérieure et extérieure avec des arêtes arrondies (13) présentant des rayons (R) compris entre 50 et 150 µm, afin d'obtenir, à l'étape e), par le revêtement complet avec le système de couches de soudure (71), une couche de métallisation (7), à faible contrainte, de la région de bord périphérique (62) usinée localement ainsi qu'un contour périphérique supplémentaire pour une soudure appliquée ultérieurement.

3. Procédé selon la revendication 1, dans lequel la région de bord (62) usinée localement est débarrassée du matériau libre et faiblement adhérent au moyen d'un processus de nettoyage et une rugosité de surface d'au plus Raₘₐₓ = 2,5 µm est établie.

4. Procédé selon les revendications 1 à 3, dans lequel le faisceau d'usinage dirigé (4) pour l'ablation, la découpe et le nettoyage est un faisceau laser, un faisceau de particules, un faisceau d'électrons, un jet de billes de verre ou un jet de liquide de gravure.

5. Procédé selon la revendication 1, dans lequel
- la découpe des éléments de fenêtre (6) est effectuée en coupant le matériau de support (1) le long des lignes de séparation (43), commençant par la face avant, qui est une surface du matériau de support (1) destinée à la couche de métallisation soudable (7),
- le matériau de support (1) est collé au substrat de support (5) au moyen d'un adhésif par élément de fenêtre (6) avant d'être coupé, et
- les éléments de fenêtre (6) découpés dans le matériau de support (1) à l'étape g) sont séparés en détachant les éléments de fenêtre (6) du substrat de support (5).

6. Procédé selon la revendication 5, dans lequel des zones affaiblies correspondant aux lignes de séparation (43) sont introduits à la face arrière du matériau de support (1) avant le collage sur le substrat de support (1) et le découpage du matériau de support (1).

7. Procédé selon l'une quelconque des revendications 5 à 6, dans lequel, par plusieurs passages d'un faisceau d'usinage dirigé (4) de rayonnement à haute énergie sur les lignes de séparation (43),
- les éléments de fenêtre (6) sont découpés et des arêtes arrondies (13) avec des rayons (R) sont produits le long des lignes de séparation (43) ou
- le découpage des éléments de fenêtre (6) s'effectue dans le contexte de l'enlèvement de la marche abaissée (11) du matériau de support (1), ce qui produit des arêtes arrondies (13) avec des rayons (R) dans la plage des micromètres à deux ou trois chiffres le long des lignes de séparation (43).

8. Procédé selon la revendication 7, dans lequel des surfaces latérales biseautées (14) inclinées vers l'intérieur en direction d'une normale à la surface de l'élément de fenêtre (6) sont produites en plus des arêtes arrondies (13) par plusieurs passages du faisceau d'usinage dirigé (4) sur les lignes de séparation (43) lors de la découpe des éléments de fenêtre (6).

9. Procédé selon la revendication 1, dans lequel une couche de nitrure de silicium, de sulfure de zinc ou de DLC (Diamond-Like Carbon) ou une couche d'un oxyde de silicium, de magnésium, d'aluminium ou une couche d'un fluorure d'yttrium, d'ytterbium, de baryum ou une couche semi-conductrice de germanium ou de silicium est utilisée comme couche finale du revêtement optique (2).

10. Procédé selon la revendication 1, dans lequel une couche protectrice métallique (3) est appliquée sur le revêtement optique (2) en tant que couche protectrice (3).

11. Procédé selon la revendication 1, dans lequel une couche de polymère est appliquée sur le revêtement optique (2) en tant que couche protectrice (3).

12. Eléments de fenêtre de forme libre pour des ouvertures de forme arbitraire d'un boîtier (9) pour le soudage hermétique dans le boîtier (9) avec au moins un revêtement optique (2) sur au moins une surface d'un matériau de support (1) plat et optiquement transparent, avec une région de bord (62) abaissée d'une marche (11) et entourant périphériquement au moins une surface optiquement active, où ladite marche (11) dans la région de bord périphérique (62) autour de la surface optiquement active est enlevée jusqu'en dessous d'un niveau de hauteur du matériau de support (1) occupé par le revêtement optique (2) et est couverte par une couche de métallisation (7), **caractérisé en ce que**
- la région de bord périphérique (62) présente une rugosité définie homogène produite par ablation locale avec un faisceau d'usinage dirigé (4) de rayonnement à haute énergie,
- ladite au moins une surface optiquement active entourée par la région de bord périphérique (62) enlevée par usinage local avec le faisceau d'usinage dirigé (4) est une surface de forme libre (61) présentant une forme géométrique quelconque avec une région de bord (62) qui est incurvée au moins par sections,
- la région de bord périphérique (62) dans la région de ladite marche (11) est abaissée, par rapport au niveau de hauteur du matériau de support (1) occupé par le revêtement optique (2), de plus de l'épaisseur d'une seule couche du revêtement optique (2) et est encore abaissée par une marche supplémentaire (12) dans la région de bord extérieure,
- ladite marche (11) et la marche supplémentaire (12) sont abaissées dans le matériau de support (1) avec des surfaces arrondies et
- la région de bord (62) de ladite marche (11) à la marche supplémentaire (12) présente une rugosité définie homogène due au même enlèvement au moyen du faisceau d'usinage dirigé (4) et est recouverte d'une couche de métallisation (7) sous la forme d'un système de couches de soudure (71).

13. Eléments de fenêtre à forme libre selon la revendication 12, **caractérisés en ce que** ladite marche abaissée (11) dans une région de bord intérieure et la marche supplémentaire (12) dans une région de bord extérieure ont des arêtes arrondies (13) avec des rayons (R) compris entre 50 et 150 µm.

14. Eléments de fenêtre de forme libre selon la revendication 12 ou 13, **caractérisés en ce que** dans le système de couches de soudure (71), dans la région de bord (62) autour de la surface de forme libre optiquement active (61) de l'élément de fenêtre (6), ladite marche (11) est réalisée dans une plage de soudure plane de 50 µm - 200 µm, et dans la région de bord extérieure (62), la marche supplémentaire (12) est réalisée dans la plage de 200 µm - 500 µm.

15. Utilisation des éléments de fenêtre de forme libre selon l'une quelconque des revendications 12 à 14 pour des ouvertures de forme arbitraire d'un boîtier (9) pour la fabrication de composants optoélectroniques ou électro-optiques étanches au gaz ou au vide.
